# EUROPEAN PATENT APPLICATION

(11) **EP 1 640 768 A1**
(43) Date of publication of application: **29.03.2006**
(21) Application number: 05255661.0
(22) Date of filing: 14.09.2005
(51) Int. Cl.: G02B 26/00, B81B 3/00

(54) **Method of selective etching using etch stop layer**

(30) Priority: 27.09.2004 US 613410 P; 25.03.2005 US 90773
(71) Applicant: IDC, LLC, San Francisco, CA 94107 (US)
(72) Inventor: Chui, Clarence, San Mateo California 94402 (US); Gally, Brian J., Los Gatos California 95032 (US); Kothari, Manish, Cupertino Califormia 95014 (US); Tung, Ming-Hau, San Francisco California 94122 (US)
(74) Representative: Dunlop, Hugh Christopher

(57) **Abstract**

The fabrication of a MEMS device such as an interferometric modulator is improved by employing an etch stop layer (44) between a sacrificial layer (46) and a mirror layer (38). The etch stop may reduce undesirable over-etching of the sacrificial layer and the mirror layer. The etch stop layer may also serve as a barrier layer, buffer layer, and/or template layer.

## Description

### Background

### Field of the Invention

The field of the invention relates to microelectromechanical systems (MEMS).

### Description of the Related Technology

Microelectromechanical systems (MEMS) include micro mechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by a gap. Such devices have a wide range of applications, and it would be beneficial in the art to utilize and/or modify the characteristics of these types of devices so that their features can be exploited in improving existing products and creating new products that have not yet been developed.

### Summary

The systems, methods, and devices described herein each have several aspects, no single one of which is solely responsible for its desirable attributes. Without limiting the scope of this invention, its more prominent features will now be discussed briefly. After considering this discussion, and particularly after reading the section entitled "Detailed Description of the Preferred Embodiments" one will understand how the various embodiments described herein provide advantages over other methods and display devices.

An aspect provides an unreleased interferometric modulator that includes a sacrificial layer, a metal mirror layer over the sacrificial layer, and a uniform layer between the sacrificial layer and the metal mirror layer.

Another aspect provides a method of making an interferometric modulator that includes depositing a sacrificial layer over a first mirror layer, depositing an etch stop layer over the sacrificial layer, and depositing a second mirror layer over the etch stop layer. A portion of the second mirror layer is then removed to expose the etch stop layer, thereby forming an exposed portion of the etch stop layer and an unexposed portion of the etch stop layer. The unexposed portion of the etch stop layer underlies a remaining portion of the second mirror layer.

Another aspect provides a method of making an interferometric modulator that includes depositing a sacrificial layer over a first mirror layer, depositing an etch stop layer over the sacrificial layer, depositing a second mirror layer over the etch stop layer, and removing the sacrificial layer to expose a portion of the etch stop layer underlying the second mirror layer.

Another aspect provides a method of making an interferometric modulator that includes depositing a sacrificial layer over a first mirror layer. The sacrificial layer includes a material selected from amorphous silicon, germanium and/or molybdenum. The method further includes depositing a thin uniform layer over the sacrificial layer. Preferably, the thin uniform layer has a thickness in the range of about 100 Å to about 700 Å. The thin uniform layer includes a silicon oxide, amorphous silicon, a silicon nitride, germanium, titanium, and/ortungsten. The method further includes depositing a second mirror layer over the thin uniform layer. The second mirror layer includes a metal such as Al, Al-Si, Al-Cu, Al-Ti, and/or Al-Nd. The method further includes removing a portion of the second mirror layer to expose the thin uniform layer, thereby forming an exposed portion of the thin uniform layer and an unexposed portion of the thin uniform layer. The unexposed portion of the thin uniform layer underlies a remaining portion of the second mirror layer. The method further includes removing the sacrificial layer to expose the previously unexposed portion of the thin uniform layer underlying the remaining portion of the second mirror layer.

These and other aspects will be better understood from the embodiments described in greater detail below.

### Brief Description of the Drawings

These and other features of this invention will now be described with reference to the drawings of preferred embodiments (not to scale) which are intended to illustrate and not to limit the invention.
Figure 1 is an isometric view depicting a portion of one embodiment of an interferometric modulator display in which a movable reflective layer of a first interferometric modulator is in a relaxed position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and column voltages that may be used to drive an interferometric modulator display.
Figures 5A and 5B illustrate one exemplary timing diagram for row and column signals that may be used to write a frame of display data to the 3x3 interferometric modulator display of Figure 2.
Figure 6A is a cross section of the device of Figure 1.
Figure 6B is a cross section of an alternative embodiment of an interferometric modulator.
Figure 6C is a cross section of another alternative embodiment of an interferometric modulator.
Figure 7 is a cross-sectional view showing an embodiment of an unreleased interferometric modulator.
Figures 8A-8E are cross-sectional views illustrating the initial process steps in an embodiment of a method for making an array of interferometric modulators.
Figures 9A-9H are cross-sectional views illustrating the later process steps in the embodiment of a method for making an array of interferometric modulators.

### Detailed Description of the Preferred Embodiments

An embodiment provides a method for making an interferometric modulator that involves the use of an etch stop between the upper mirror layer and the sacrificial layer. Both unreleased and released interferometric modulators may be fabricated using this method. The etch stop can be used to reduce undesirable over-etching of the sacrificial layer and the upper mirror layer. The etch stop layer may also serve as a barrier layer, buffer layer, and/or template layer.

The following detailed description is directed to certain specific embodiments of the invention. However, the invention can be embodied in a multitude of different ways. In this description, reference is made to the drawings wherein like parts are designated with like numerals throughout. As will be apparent from the following description, the embodiments may be implemented in any device that is configured to display an image, whether in motion (e.g., video) or stationary (e.g., still image), and whether textual or pictorial, and/or processes for making such devices. More particularly, it is contemplated that the embodiments may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

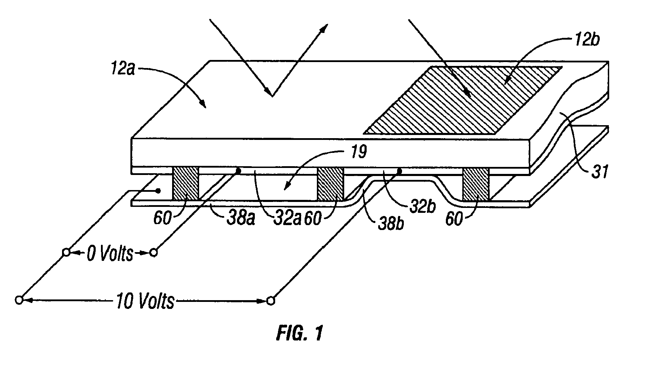

One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure 1 is an isometric view depicting two adjacent pixels in a series of pixels of a visual display, wherein each pixel comprises a MEMS interferometric modulator. In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the relaxed state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators **12a** and **12b.** In the interferometric modulator **12a** on the left, a movable and highly reflective layer **38a** is illustrated in a relaxed position at a predetermined distance from a fixed partially reflective layer **32a.** In the interferometric modulator **12b** on the right, the movable highly reflective layer **38b** is illustrated in an actuated position adjacent to the fixed partially reflective layer **32b.**

The fixed layers **32a, 32b** are electrically conductive, partially transparent and partially reflective, and may be fabricated, for example, by depositing one or more layers each of chromium and indium-tin-oxide onto a transparent substrate **31.** The layers are patterned into parallel strips, and may form row electrodes in a display device as described further below. The movable layers **38a, 38b** may be formed as a series of parallel strips of a deposited metal layer or layers (orthogonal to the row electrodes **32a, 32b)** deposited on top of posts **60** and an intervening sacrificial material deposited between the posts **60.** When the sacrificial material is etched away, the deformable metal layers **38a, 38b** are separated from the fixed conductive/partially reflective metal layers **32a, 32b** by a defined gap **19.** A highly conductive and reflective material such as aluminum may be used for the deformable layers, and these strips may form column electrodes in a display device.

With no applied voltage, the cavity **19** remains between the layers **38a, 32a** and the deformable layer is in a mechanically relaxed state as illustrated by the pixel **12a** in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer **32a**, **32b** to prevent shorting and control the separation distance) as illustrated by the **pixel 12b** on the right in Figure 1. The behavior is the same regardless of the polarity of the applied potential difference. In this way, row/column actuation that can control the reflective vs. non-reflective pixel states is analogous in many ways to that used in conventional LCD and other display technologies.

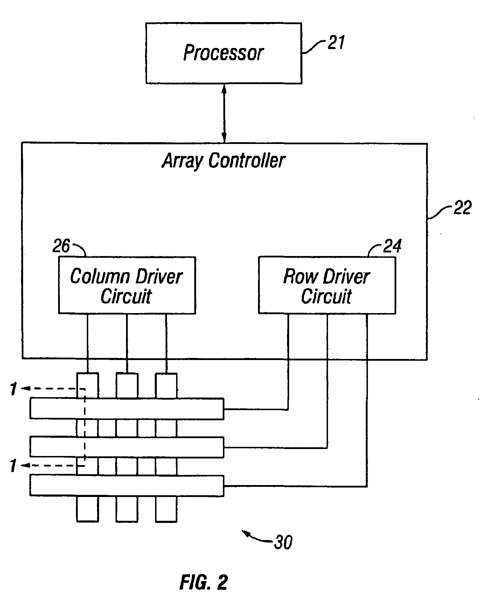

Figures 2 through 5 illustrate one exemplary process and system for using an array of interferometric modulators in a display application. Figure 2 is a system block diagram illustrating one embodiment of an electronic device that may incorporate aspects of the invention. In the exemplary embodiment, the electronic device includes a processor **21** which may be any general purpose single- or multi-chip microprocessor such as an ARM, Pentium® , Pentium II® , Pentium III® , Pentium IV® , Pentium® Pro, an 8051, a MIPS® , a Power PC® , an ALPHA® , or any special purpose microprocessor such as a digital signal processor, microcontroller, or a programmable gate array. As is conventional in the art, the processor **21** may be configured to execute one or more software modules. In addition to executing an operating system, the processor may be configured to execute one or more software applications, including a web browser, a telephone application, an email program, or any other software application.

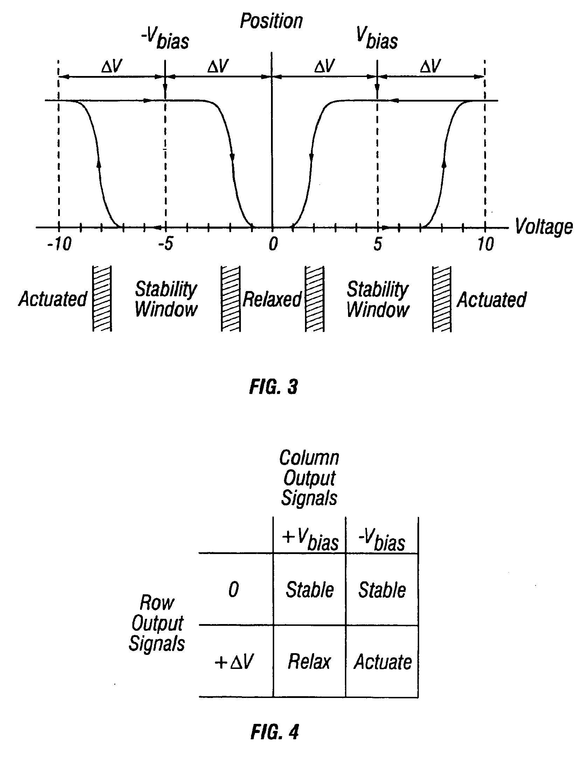

In one embodiment, the processor **21** is also configured to communicate with an array controller **22.** In one embodiment, the array controller **22** includes a row driver circuit **24** and a column driver circuit **26** that provide signals to a pixel array **30.** The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform from the relaxed state to the actuated state. However, when the voltage is reduced from that value, the movable layer maintains its state as the voltage drops back below 10 volts. In the exemplary embodiment of Figure 3, the movable layer does not relax completely until the voltage drops below 2 volts. There is thus a range of voltage, about 3 to 7 V in the example illustrated in Figure 3, where there exists a window of applied voltage within which the device is stable in either the relaxed or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be relaxed are exposed to a voltage difference of close to zero volts. After the strobe, the pixels are exposed to a steady state voltage difference of about 5 volts such that they remain in whatever state in which the row strobe put them. After being written, each pixel sees a potential difference within the "stability window" of 3-7 volts in this example. This feature makes the pixel design illustrated in Figure 1 stable under the same applied voltage conditions in either an actuated or relaxed pre-existing state. Since each pixel of the interferometric modulator, whether in the actuated or relaxed state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

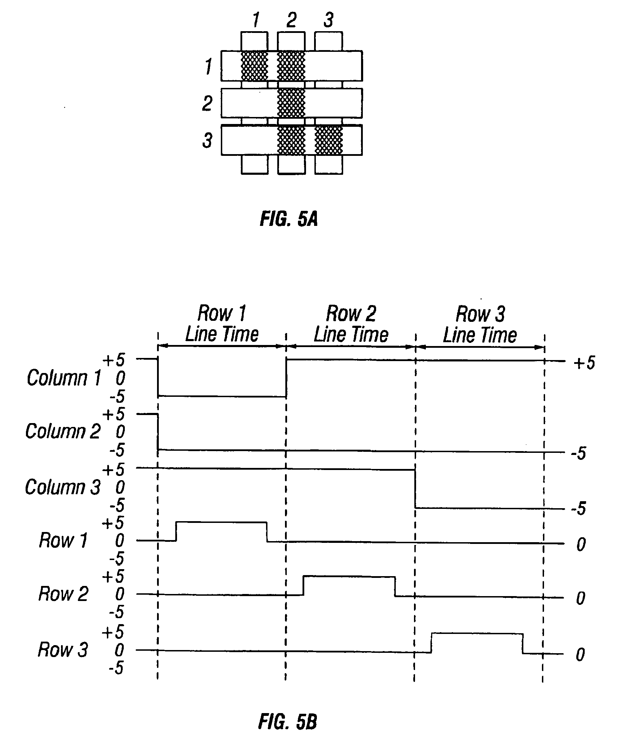

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to -V_{bias}, and the appropriate row to +ΔV, which may correspond to -5 volts and +5 volts respectively Releasing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or -V_{bias}.

Figure 5B is a timing diagram showing a series ofrow and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or relaxed states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and relaxes the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and relax pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

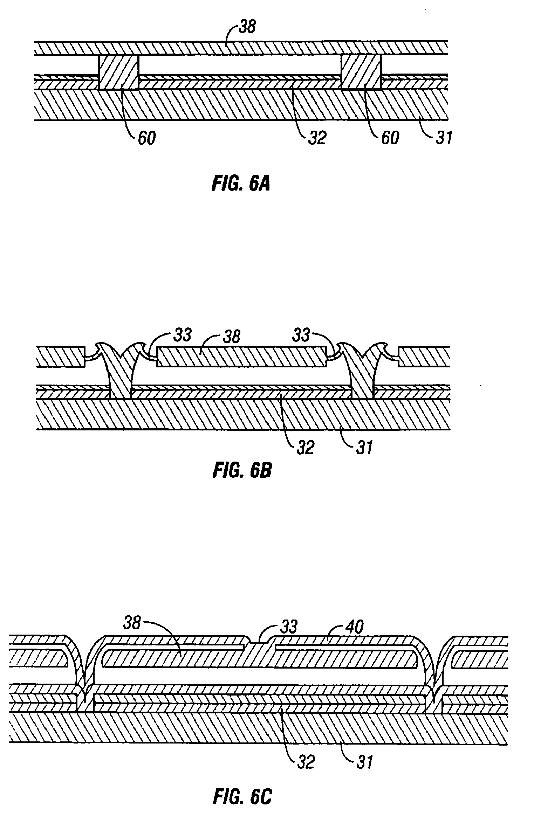

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 1, where a strip of reflective material **38** is deposited on orthogonally extending supports **60.** In Figure 6B, the moveable reflective material **38** is attached to supports **60** at the corners of the reflective material **38** only, on tethers **33.** In Figure 6C, the moveable reflective material **38** is suspended by a tether **33** from a deformable layer **40.** This embodiment has benefits because the structural design and materials used for the reflective material **38** can be optimized with respect to the optical properties, and the structural design and materials used for the deformable layer **40** can be optimized with respect to desired mechanical properties. The production of various types of interferometric devices is described in a variety of published documents, including, for example, U.S. Published Application 2004/0051929. A wide variety of known techniques may be used to produce the above described structures involving a series of material deposition, patterning, and etching steps.

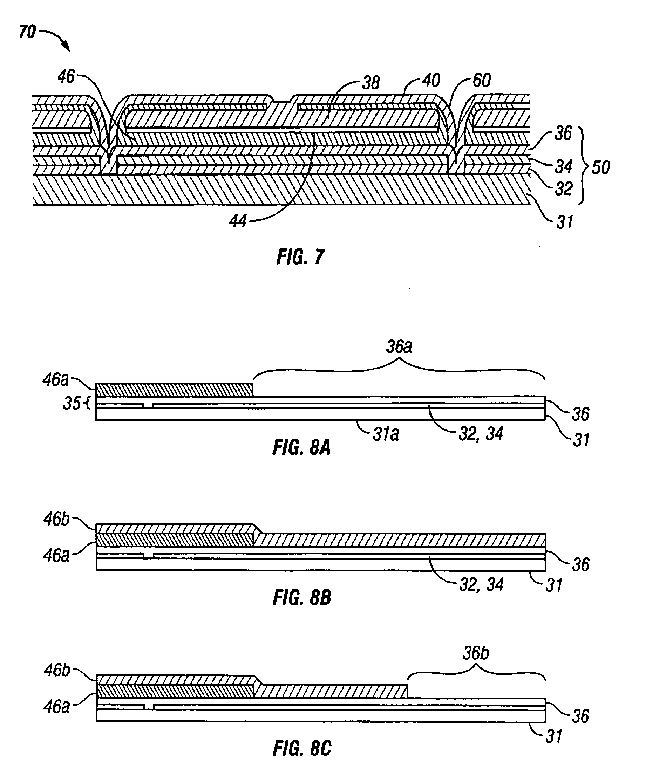

Figure 7 is a cross-sectional view illustrating an embodiment of an unreleased interferometric modulator **70** comprising a sacrificial layer **46,** an upper metal mirror layer **38** over the sacrificial layer **46** and a thin uniform layer **44** between the sacrificial layer **46** and the upper metal mirror layer **38.** The thickness of the thin uniform layer 44 is typically in the range of about 100 Å to about 700 Å. In some embodiments, the thickness of the thin uniform layer **44** is in the range of about 300 Å to about 700 Å. In the illustrated embodiment, the upper mirror layer **38** is aluminum. In other embodiments, the upper mirror **layer 38** comprises aluminum and thus may be an aluminum alloy such as, for example, Al-Si, Al-Cu, Al-Ti, or Al-Nd. The sacrificial layer **46** comprises molybdenum in the illustrated embodiment. Other suitable sacrificial materials include amorphous silicon ("a-Si") and germanium. In Figure 7, the thin uniform layer **44** comprises a silicon oxide (SiOₓ,, e.g., SiO₂), but the thin uniform layer **44** may comprise other materials such as a silicon nitride (SiₓN_{y}, e.g., SiN), a-Si, titanium, germanium and tungsten in place of or in addition to a silicon oxide. The thin uniform layer **44** is formed of a different material from both the sacrificial layer **46** and the metal mirror layer **38.** Preferably, the materials used for the fabrication of the sacrificial layer **46,** the metal mirror layer **38** and the thin uniform layer **44** are selected in combination with one another to bring about certain desired effects such as etch selectivity, resistance to diffusion (diffusion barrier), barrier to crystallographic influence, and crystallographic templating, as described in greater detail below.

The upper metal mirror layer **38** and thin uniform layer **44** are spaced from a glass substrate **31** by posts **60.** The unreleased interferometric modulator **70** also includes an electrode layer **32** over the glass substrate **31.** The electrode layer **32** may comprise a transparent metal film such as indium tin oxide (ITO) or zinc tin oxide (ZTO). A lower metal mirror layer **34** (such as chrome) and a dielectric layer **36** (such as SiO₂) are formed over the electrode layer **32.** The electrode layer **32,** lower metal mirror layer **34** and oxide layer **36** may together be referred to as an optical stack **50** that partially transmits and partially reflects light. Thethin uniform layer **44** may be included in other unreleased interferometric modulator configurations, e.g., configurations resulting in the interferometric modulators illustrated in Figures 6A and 6B.

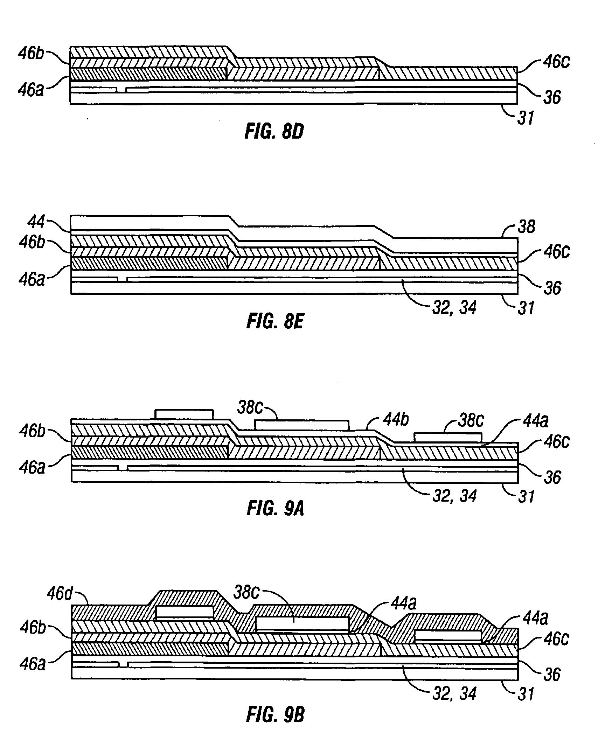

It has been found that the presence of a thin uniform layer between the metal mirror layer and the sacrificial layer (such as the thin uniform layer **44** between the sacrificial layer **46** and the metal mirror layer **38)** may significantly improve one or more aspects of various processes for making interferometric modulators (including arrays thereof), and/or may improve one or more qualities of the resulting interferometric modulators themselves. For example, the thin uniform layer **44** may comprise or serve as an etch stop layer as described below with reference to Figures 8-9 in the context of making an array of interferometric modulators of the general type illustrated in Figure 6C. In view of the illustrated embodiments, those skilled in the art will understand that similar etch stop layers may be used to manufacture other MEMS devices, including interferometric modulators of the general type illustrated in Figures 6A-6B, as well as other types of spatial light modulators. Thus, while the process described below with respect to Figures 8-9 may refer to particular steps, sequences and materials, it is understood that such details are for the purpose of illustration, and that other steps, sequences and/or materials may be used.

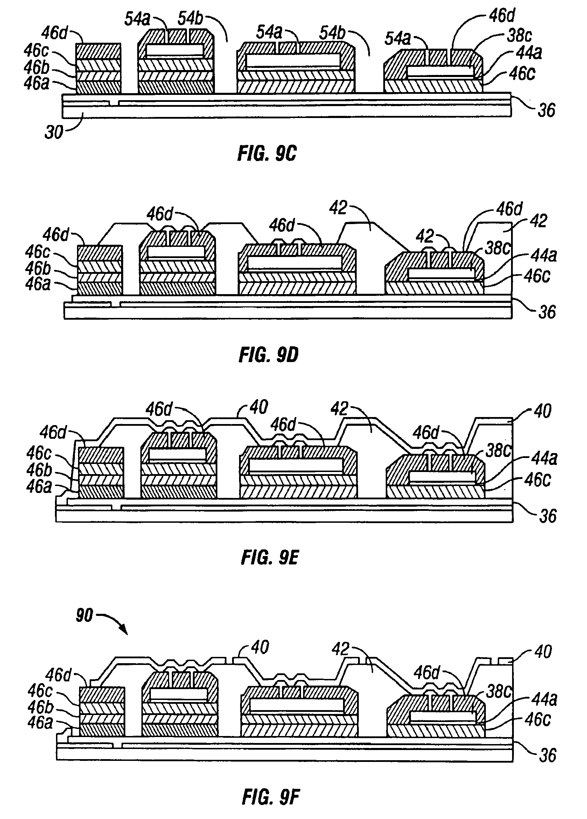

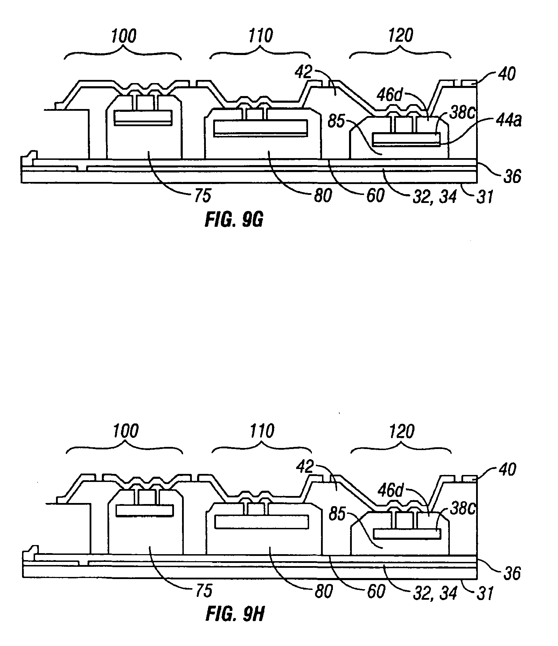

Figures 8A-8C are cross-sectional views illustrating the initial steps in a process for manufacturing an array of unreleased interferometric modulators (release by removal of the sacrificial material to form interferometric modulators is discussed below with reference to Figure 9). In Figures 8-9, the formation of an array of three interferometric modulators **100** (red subpixel), **110** (green subpixel) and **120** (blue subpixel) will be illustrated, each of the interferometric modulators **100, 110, 120** having a different distance between the oxide layer **36** and the upper metal mirror layer **38c** as indicated in Figure 9H which shows final configurations. Color displays may be formed by using three (or more) modulator elements to form each pixel in the resulting image. The dimensions of each interferometric modulator cavity (e.g., the cavities **75, 80, 85** in Figure 9H) determine the nature of the interference and the resulting color. One method of forming color pixels is to construct arrays of interferometric modulators, each having cavities of differing sizes, e.g., three different sizes corresponding to red, green and blue as shown in this embodiment. The interference properties of the cavities are directly affected by their dimensions. In order to create these varying cavity dimensions, multiple sacrificial layers may be fabricated as described below so that the resulting pixels reflect light corresponding to each of the three primary colors. Other color combinations are also possible, as well as the use of black and white pixels.

Figure 8A illustrates an optical stack **35** formed by depositing an indium tin oxide electrode layer **32** on a transparent substrate **31,** then depositing a first mirror layer **34** on the electrode layer **32.** In the illustrated embodiment, the first mirror layer **34** comprises chrome. Other reflective metals such as molybdenum and titanium may also be used to form the first mirror layer **34.** In Figures 8-9, although the electrode layer **32** and the first mirror layer **34** are indicated as a single layer **32,34,** it is understood that the first mirror layer **34** is formed on the electrode layer **32** as illustrated in Figure 7. The viewing surface **31a** of the transparent substrate **31** is on the opposite side of the substrate **31** from the first mirror layer **34** and the electrode layer **32.** In a process not shown here, the electrode and metal mirror layers **32, 34** are patterned and etched to form electrode columns, rows or other useful shapes as required by the display design. As indicated in Figure **8A,** the optical stack **35** also includes an oxide dielectric layer **36** over the metal layer **32,** typically formed after the electrode and metal mirror layers **32, 34** have been patterned and etched.

Figure 8A further illustrates a first pixel sacrificial layer **46a** formed by depositing molybdenum over the optical stack **35** (and thus over the oxide dielectric layer **36,** first mirror layer **34** and electrode layer **32).** The molybdenum is etched to form the first pixel sacrificial layer **46a,** thereby exposing a portion **36a** of the oxide dielectric layer **36** that will ultimately be included in the resulting green and blue interferometric modulators **110, 120** (Figure 9H). The thickness of the first sacrificial layer **46a** (along with the thicknesses of subsequently deposited layers as described below) influences the size of the corresponding cavity **75** (Figure 9H) in the resulting interferometric modulator **100.**

Figures 8B-8C illustrate forming a second pixel sacrificial layer **46b** by deposition, masking and patterning over the exposed portion **36a** of the oxide dielectric layer **36** and the first pixel sacrificial layer **46a.** The second pixel sacrificial layer **46b** preferably comprises the same sacrificial material as the first pixel sacrificial layer **46a** (molybdenum in this embodiment). The second pixel sacrificial layer **46b** is patterned and etched as illustrated in Figure **8C** to expose a portion **36b** of the oxide dielectric layer **36** that will ultimately be included in the resulting blue interferometric modulator **120** (Figure 9H). A third pixel sacrificial layer **46c** is then deposited over the exposed portion **36b** of the oxide dielectric layer **36** and the second pixel sacrificial layer **46b** as illustrated in Figure 8D. The third pixel sacrificial layer **46c** need not be patterned or etched in this embodiment, since its thickness will influence the sizes of all three cavities **75, 80, 85** in the resulting interferometric modulators **100, 110 120** (Figure 9H). The three deposited pixel sacrificial layers **46a, 46b, 46c** do not necessarily have the same thickness.

Figure 8E illustrates forming an etch stop layer **44** by depositing an oxide (e.g., SiO₂) over the third pixel sacrificial layer **46c,** followed by depositing an aluminum-containing metal over the oxide etch stop layer **44** to form a second mirror layer **38.** In the illustrated embodiment, the second mirror layer **38** also serves as an electrode. The second mirror layer **38** is preferably deposited immediately or very soon after the etch stop layer **44** is deposited. In an embodiment, the second mirror layer **38** is deposited over the etch stop layer **44** immediately after depositing the etch stop layer **44,** preferably in the same deposition chamber and without breaking a vacuum, resulting in reduced oxidation of the surface of the second mirror layer **38.** The thickness of the etch stop layer **44** may be in the range of about 100 Å to about 700 Å, preferably in the range of about 100 Å to about 300 Å. For embodiments in which the etch stop layer **44** is also a diffusion barrier, the thickness of the etch step layer is preferably in the range of from about 300 Å to about 700 Å. Although the foregoing description refers to certain exemplary materials for the fabrication of the various layers illustrated in Figures 8-9, it will be understood that other materials may also be used, e.g., as described above with reference to Figure 7.

Figures 9A-9H are cross-sectional views illustrating various later steps following the process steps illustrated in Figure 8. In Figure 9A, the second mirror layer **38** (comprising aluminum in this embodiment) has been patterned and etched using an appropriate etch chemistry for the removal of the metal. Such etch chemistries are known to those skilled in the art. For example, a PAN etch (aqueous phosphoric acid/acetic acid/nitric acid) may be suitable for removing the metal. Remaining portions **38c** of the second mirror layer **38** are protected by a mask (not shown) and thus are not removed during etching. The second mirror layer **38** may include a metal such as Al, Al-Si, Al-Cu, Al-Ti, and/or Al-Nd. During etching of the second mirror layer **38** to form the second mirror portions **38c**, the etch stop layer **44** protects the underlying third sacrificial layer **46c** from being etched. Etching of the second mirror layer **38** to form the portions **38c** exposes portions **44b** of the etch stop layer **44**. The unexposed portions **44a** of the etch stop layer **44** underlie the remaining second mirror portions **38c**. The exposed portions **44b** of the etch stop layer **44** are then removed (Figure 9B) by further etching using a different etch chemistry (e.g., hydrofluoric acid (HF) etch) which does not remove the third sacrificial layer **46c** so that the portions **44a** underlying the remaining metal mirror layer **38c** remain.

Thus, Figure 9A illustrates removing a portion of the second mirror layer **38** to expose the etch stop layer **44**, thereby forming an exposed portion **44b** of the etch stop layer **44** and an unexposed portion **44a** of the etch stop layer. The unexposed portion **44a** of the etch stop layer **44** underlies the remaining portion **38c** of the second mirror layer **38**. The exposed portion **44a** of the etch stop layer **44** is then removed to expose the underlying third sacrificial layer **46c**. In an alternate embodiment, the second mirror layer **38** and the etch stop layer **44** are removed using the same etchant, e.g., HF. In another alternate embodiment, the thin uniform layer **44** is removed at a later stage, e.g., when the sacrificial layers are removed.

Figure 9B illustrates the formation of a fourth sacrificial layer **46d** over the patterned second mirror layer **38c** and the third sacrificial layer **46c**. Figure 9C illustrates forming post holes **54b** and connector holes **54a** by patterning and etching the fourth sacrificial layer **46d**. In Figure 9D, a planarization material **42** is optionally applied to fill in the post holes **54b** and connector holes **54a**. Examples of planarization materials include, but are not limited to,silicon dioxide, silicon nitride, organic materials (e.g., epoxies, acrylics, and vinyl-based chemistries), and silicon- or metal-containing organometallics. In an embodiment, various polyimides, low-k materials, and spin-on glasses may be used. Figure 9E illustrates forming a mechanical film (flex or deformable layer) **40** by depositing a flexible materials such as a metal over the planarization material **42** and the fourth sacrificial layer **46d**, followed by patterning and etching the mechanical layer **40** to form an array of unreleased interferometric modulators **90** (Figure 9F). In an embodiment (not shown), the planarization material **42** is not used, in which case the post holes **54b** and connector holes **54a** may be filled with the material used to form the mechanical layer **40**.

Figure 9G illustrates removing the sacrificial layers **46a, 46b, 46c, 46d** to form the cavities **75, 80, 85**, thereby exposing the portion **44a** of the etch stop layer **44** underlying the remaining portion **38c** of the mirror layer **38**. In the illustrated embodiment, gaseous or vaporous XeF₂ is used as an etchant to remove the molybdenum sacrificial layers **46a**, **46b, 46c, 46d**. It is understood that XeF₂ may serve as a source of fluorine-containing gases such as F₂ and HF, and thus F₂ or HF may be used in place of or in addition to XeF₂ as an etchant for the preferred sacrificial materials. The etch stop layer **44a** (underlying the second mirror layer **38c**) that is exposed by the removal of the sacrificial layers **46a, 46b, 46c** protects the second mirror layer **38c** during the etching of the sacrificial layers **46a, 46b, 46c, 46d**. The planarization material **42** is not removed by the etchant and thus remains to form posts **60** (Figure 9H). The etch stop layer **44a** underlying the second mirror layer **38c** is then itself removed by etching using an appropriate etch chemistry (e.g., SF₆ plasma etch) as illustrated in Figure 9H, thereby exposing the mirror surface **38d** of the second mirror layer **38c**. In an alternate embodiment, the etch stop layer **44a** and the sacrificial layers **46a, 46b, 46c, 46d** are removed using the same etchant. For example, a very thin SiO₂ etch stop layer may be removed by an XeF₂ etchant used to removed a molybdenum sacrificial layer.

A comparison of Figures 9H and 8E illustrates that the size of the cavity **75** (Figure 9H) corresponds to the combined thicknesses of the three sacrificial layers **46a, 46b, 46c** and the etch stop layer **44**. Likewise, the size of the cavity **80** corresponds to the combined thickness of two sacrificial layers **46b, 46c** and the etch stop layer **44**, and the size of the cavity 85 corresponds to the combined thicknesses of the sacrificial layer **46c** and the etch stop layer **44**. Thus, the dimensions of the cavities **75, 80, 85** vary according to the various combined thicknesses of the four layers **46a, 46b, 46c, 44,** resulting in an array of interferometric modulators **100, 110, 120** capable of displaying three different colors such as red, green and blue.

The materials used for the fabrication of the sacrificial layer(s) **46**, the metal mirror layer **38** and the thin uniform layer **44** are preferably selected in combination with one another to bring about certain desired effects. In an embodiment in which the sacrificial layer(s)**46** comprises a-Si or germanium and in which the metal mirror layer **38** comprises a metal such as aluminum, the thin uniform layer **44** preferably has a thickness in the range of about 100Å to about 700 Å and preferably comprises a material selected from the group consisting of titanium and tungsten. In an embodiment in which the sacrificial layer(s) **46** comprises molybdenum and in which themetal mirror layer **38** comprises a metal such as aluminum, the thin uniform layer **44** preferably has a thickness in the range of about 100Å to about 700 Å and preferably comprises a material selected from the group consisting of a silicon oxide (SiOₓ), amorphous silicon, a silicon nitride (SiₓN_{y}), germanium, titanium, and tungsten.

In various embodiments, the unreleased interferometric modulator(e.g., the modulator **70**) may include means for slowing diffusion of metal from the metal mirror layer(e.g., the layer **38**) into the sacrificial layer (e.g., the layer **46**) and/or means for substantially preventing a crystallographic orientation of the sacrificial layer (e.g., the layer **46**) from producing a corresponding crystallographic orientation of the metal mirror layer (e.g., the layer **38**). The thin uniform layer (e.g., the layer **44**) may include an etch stop layer, a diffusion barrier layer, a buffer layer, and/or a template layer. Thus, the means for slowing diffusion of metal from the metal mirror layer into the sacrificial layer may include a diffusion barrier layer, and/or the means for substantially preventing a crystallographic orientation of the sacrificial layer from producing a corresponding crystallographic orientation of the metal mirror layer may include a buffer layer. In an embodiment, the sacrificial layer includes amorphous silicon, germanium and/or molybdenum. In an embodiment, the thin uniform layer (e.g., the layer **44**) includes a silicon oxide, amorphous silicon, a silicon nitride, germanium, titanium, and/or tungsten. In any particular interferometric modulator, the material used to form the sacrificial layer(e.g., the layer **46**) is generally different than the material used to form the thin uniform layer (e.g., the etch stop layer).

In an embodiment, the thin uniform layer **44** comprises or serves as a diffusion barrier layer that slows diffusion of metal from the metal mirror layer **38** into the sacrificial material **46**. It has been found that such diffusion is often undesirable because it tends to blur the boundary between the metal mirror layer and the sacrificial layer, resulting in reduced etch selectivity during processing and reduced mirror quality in the resulting interferometric modulator. In an embodiment in which the thin uniform layer **44** comprises or serves as a diffusion barrier layer; in which the sacrificial material **46** comprises a material selected from the group consisting of a-Si, germanium and molybdenum; and in which the metal mirror layer **38** comprises aluminum, the thin uniform layer/barrier layer **44** preferably comprises a material selected from the group consisting of a silicon oxide (SiOₓ), a silicon nitride (SiₓN_{y}), titanium and tungsten. The thin uniform layer/barrier layer **44** preferably has a thickness in the range of about 300 Å to about 700 Å. In a preferred embodiment, the thin uniform layer **44** comprises or serves as both an etch stop layer and a barrier layer.

In an embodiment, the thin uniform layer **44** comprises or serves as a buffer layer that substantially prevents a crystallographic orientation of the sacrificial material **46** from producing a corresponding crystallographic orientation of the metal mirror layer **38**. It has been found that some materials used to form the sacrificial layer display a crystallographic orientation after deposition and/or subsequent processing steps. For example, molybdenum is a crystalline material having a crystallographic orientation (typically body centered cubic) on any particular surface that results from the crystalline lattice spacing of the molybdenum atoms. When a metal mirror layer **38** is deposited directly onto a molybdenum sacrificial material **46**, the depositing metal may tend to follow the crystallographic orientation of the underlying molybdenum, producing a corresponding crystallographic orientation in the metal layer **38**. The lattice spacing of the resulting deposited metal layer is often different than it would be in the absence of the underlying molybdenum, and in many cases the deposited metal layer is mechanically strained as a result. Upon removal of the sacrificial layer, the as-deposited lattice spacing of the metal atoms may relax to the natural lattice spacing for the metal, in some cases changing the dimensions of the metal layer and producing undesirable warping.

For embodiments in which the thin uniform layer **44** comprises or serves as a buffer layer, the thin uniform layer/buffer layer **44** is preferably amorphous or does not have the same lattice spacing as the underlying sacrificial layer **46**. The metal atoms deposit on the thin uniform layer/buffer layer rather than on the underlying sacrificial layer **46**, and the buffer layer substantially prevents a crystallographic orientation of the sacrificial layer **46** from producing a corresponding crystallographic orientation of the metal mirror layer **38**. In an embodiment in which the thin uniform layer **44** comprises or serves as a buffer layer; in which the sacrificial layer **46** comprises a material selected from the group consisting of germanium and molybdenum; and in which the metal mirror layer **38** comprises aluminum, the thin uniform layer/buffer layer **44** preferably comprises a material selected from the group consisting of a silicon oxide (SiOₓ) and a silicon nitride (SiₓN_{y}). The thin uniform layer/buffer layer **44** preferably has a thickness in the range of about 100 Å to about 700 Å. In a preferred embodiment, the thin uniform layer **44** comprises or serves as both an etch stop layer and a buffer layer.

In an embodiment, the thin uniform layer **44** comprises or serves as a template layer having a crystalline orientation that is substantially similar to a crystallographic orientation of the metal mirror layer. As discussed above, a depositing metal may tend to follow the crystallographic orientation of the underlying layer, producing a corresponding crystallographic orientation in the metal layer. This tendency may be used to advantage by selecting, for use asa thin uniform layer **44**, a material that has a crystallographic orientation that would be desirable to impart to the metal layer. A thin uniform layer **44** formed of such a material thus serves as a crystallographic template that produces a substantially similar crystalline orientation in the subsequently deposited metal mirror layer **38**. In an embodiment in which the thin uniform layer **44** also comprises or serves as a template layer; in which the sacrificial layer **46** comprises a material selected from the group consisting of a-Si, germanium and molybdenum; and in which the metal mirror layer **38** comprises aluminum, the thin uniform layer/template layer **44** preferably comprises a material selected from the group consisting of titanium and tungsten. The thin uniform layer/template layer **44** preferably has a thickness in the range of about 100 Å to about 700 Å. In a preferred embodiment, the thin uniform layer **44** comprises or serves as both an etch stop layer and a template layer.

The processing steps used to fabricate the interferometric modulators and arrays thereof described herein are preferably selected in combination with the materials used for the fabrication of the sacrificial layer **46**, the metal mirror layer **38** and the thin uniform layer **44** to bring about certain desired effects. For example, in one embodiment described above with reference to Figure 9A, during etching of the second mirror layer **38** to form the portions **38c**, the etch stop layer **44** protects the underlying third sacrificial layer **46c** from being etched. In another embodiment described above with reference to Figure 9G, the etch stop layer **44a** (underlying the second mirror layer **38c**) that is exposed by the removal of the sacrificial layers **46a, 46b, 46c** protects the second mirror layer **38c** during the etching of the sacrificial layers **46a, 46b, 46c, 46d**. Thus, the etch stop layer may protect a sacrificial layer and/or a mirror layer from being etched during the removal of some other layer. During such etching, the material being etched(e.g., the sacrificial layer) is preferably removed at a rate that is at least about 5 times faster than the rate at which the etch stop layer is removed, more preferably at least about 10 times faster, even more preferably at least about 20 times faster. Thus, for example, with reference to Figure 9A, during etching of the second mirror layer **38** to form the portions **38c**, the aluminum in the second mirror layer **38** is preferably removed by the etchant at a rate that is at least about 10 times faster than the rate at which the oxide in the etch stop layer **44** is removed by the etchant, and more preferably at least about 20 times faster. Likewise, with reference to Figure 9G, during etching of the sacrificial layers **46a, 46b, 46c, 46d**, the molybdenum in the sacrificial layers **46a, 46b, 46c**, **46d** is preferably removed by the XeF₂ etchant at a rate that is at least about 10 times faster than the rate at which the oxide in the etch stop layer **44** is removed by the XeF₂ etchant, and more preferably at least about 20 times faster.

With reference to Figures 9G-9H, the portions **44a** of the etch stop layer **44** underlying the second mirror portions **38c** may be selectively removed by etching to expose the mirror surfaces **38d** of the second mirror portions **38c** in a manner that minimizes damage to the mirror surfaces **38d**. The etchant preferably removes the portions **44a** of the etch stop layer **44** at a rate that is at least about 5 times faster than a rate at which the etchant removes the second mirror portions **38c,** more preferably at least about 10 times faster, even more preferably at least about 20 times faster. The etch chemistry employed for the removal of the portions **44a** is preferably different than the etch chemistry used for the removal of the sacrificial layer(s)**46**. For example, removal of the molybdenum sacrificial layer(s) **46** from throughout the unreleased interferometric modulator **90** (Figure 9F) may involve over-etching by XeF₂ in order to achieve the desired degree of removal, particularly in thick sections or less accessible regions. Such over-etching, in the absence of the portions **44a** of the etch stop layer **44** underlying the second mirror portions **38c**, could result in damage to the mirror surfaces 38d. Therefore, it is preferred that a first etchant be used to selectively remove the sacrificial layer(s) **46** relative to the portions **44a** of the etch stop layer **44**, and that a second etchant be used to selectively remove the portions **44a** relative to the second mirror portions **38c**. Since the portions **44a** are thin and relatively uniform, over-etching is not necessary, and damage to the mirror surfaces **38d** may be minimized.

The above embodiments are not intended to limit the present invention, and the methods described herein may be applied to any structure in which two materials having similar etching profiles are used in a proximate area and subjected to etching where selective etching is desired. Preferably, the methods described herein may be applied to increase etch selectivity between combinations of an Al-containing material and a Mo-containing material. No structural limitation or restriction is imposed or intended. Further, no limitation or restriction is imposed or intended on the particular formation sequence.

The methods described herein for the fabrication of interferometric modulators may use conventional semiconductor manufacturing techniques such as photolithography, deposition (e.g., "dry" methods such as chemical vapor deposition (CVD) and wet methods such as spin coating), masking, etching (e.g., dry methods such as plasma etch and wet methods), etc.

It will be appreciated by those skilled in the art that various omissions, additions and modifications may be made to the processes described above without departing from the scope of the invention, and all such modifications and changes are intended to fall within the scope of the invention, as defined by the appended claims.

## Claims

1. An unreleased interferometric modulator comprising:
a sacrificial layer;
a metal mirror layer over the sacrificial layer; and
a uniform layer between the sacrificial layer and the metal mirror layer.

2. The unreleased interferometric modulator of Claim 1, wherein the sacrificial layer comprises at least one of amorphous silicon, germanium and molybdenum.

3. The unreleased interferometric modulator of Claim 2, wherein the uniform layer comprises an etch stop layer.

4. The unreleased interferometric modulator of Claim 3, wherein the etch stop layer comprises at least one of silicon oxide, amorphous silicon, a silicon nitride, germanium, titanium, and tungsten.

5. The unreleased interferometric modulator of Claim 3, wherein the sacrificial layer comprises at least one of germanium and molybdenum.

6. The unreleased interferometric modulator of Claim 3, wherein the sacrificial layer comprises amorphous silicon and the uniform layer comprises at least one of titanium and tungsten.

7. The unreleased interferometric modulator of Claim 2 additionally comprising means for slowing diffusion of metal from the metal mirror layer into the sacrificial layer.

8. The unreleased interferometric modulator of Claim 7, wherein the slowing means comprises a diffusion barrier layer.

9. The unreleased interferometric modulator of Claim 8, wherein the diffusion barrier layer comprises at least one of a silicon oxide, a silicon nitride, titanium, and tungsten.

10. The unreleased interferometric modulator of Claim 2 additionally comprising means for substantially preventing a crystallographic orientation of the sacrificial layer from producing a corresponding crystallographic orientation of the metal mirror layer.

11. The unreleased interferometric modulator of Claim 10, wherein the preventing means comprises a buffer layer.

12. The unreleased interferometric modulator of Claim 11, wherein the buffer layer comprises at least one of a silicon oxide and a silicon nitride.

13. The unreleased interferometric modulator of Claim 2, wherein the uniform layer comprises a template layer having a crystalline orientation that is substantially similar to a crystallographic orientation of the metal mirror layer.

14. The unreleased interferometric modulator of Claim 13, wherein the template layer comprises at least one of titanium and tungsten.

15. The unreleased interferometric modulator of Claim 1, wherein the metal mirror layer comprises aluminum.

16. The unreleased interferometric modulator of Claim 15, wherein the metal mirror layer comprises at least one of Al-Si, Al-Cu, Al-Ti, and Al-Nd.

17. The unreleased interferometric modulator of Claim 1, wherein the uniform layer has a thickness in the range of about 100 Å to about 700 Å.

18. A method of making an interferometric modulator, comprising:
depositing a sacrificial layer over a first mirror layer;
depositing an etch stop layer over the sacrificial layer;
depositing a second mirror layer over the etch stop layer; and
removing the sacrificial layer to expose a portion of the etch stop layer underlying the second mirror layer.

19. The method of Claim 18 further comprising selectively removing the portion of the etch stop layer underlying the second mirror layer.

20. The method of Claim 19, wherein selectively removing the portion of the etch stop layer underlying the second mirror layer comprises etching the portion of the etch stop layer using an etchant that removes the portion of the etch stop layer at a rate that is at least about 10 times faster than a rate at which the etchant removes the second mirror layer.

21. The method of Claim 18, wherein removing the sacrificial layer comprises etching the sacrificial layer using an etchant that removes the sacrificial layer at a rate that is at least about 10 times faster than a rate at which the etchant removes the etch stop layer.

22. The method of Claim 21, wherein the etchant comprises XeF₂.

23. The method of Claim 18, wherein the sacrificial layer comprises at least one of amorphous silicon, germanium and molybdenum.

24. The method of Claim 18, wherein the etch stop layer comprises at least one of a silicon oxide, amorphous silicon, a silicon nitride, germanium, titanium, and tungsten.

25. An interferometric modulator made or manufacturable by the method of any one of Claims 18 to 24.

26. A method of making an interferometric modulator, comprising:
depositing a sacrificial layer over a first mirror layer;
depositing an etch stop layer over the sacrificial layer;
depositing a second mirror layer over the etch stop layer; and
removing a portion of the second mirror layer to expose the etch stop layer, thereby forming an exposed portion of the etch stop layer and an unexposed portion of the etch stop layer, the unexposed portion of the etch stop layer underlying a remaining portion of the second mirror layer.

27. The method of Claim 26 further comprising removing the exposed portion of the etch stop layer.

28. The method of Claim 27 further comprising selectively removing the sacrificial layer to expose the portion of the etch stop layer underlying the remaining portion of the second mirror layer.

29. The method of Claim 28 further comprising selectively removing the etch stop layer underlying the remaining portion of the second mirror layer.

30. An interferometric modulator made by the method of Claim 29.

31. The method of Claim 26, wherein removing the portion of the second mirror layer to expose the etch stop layer comprises etching the second mirror layer using an etchant that removes the second mirror layer at a rate that is at least about 10 times faster than a rate at which the etchant removes the etch stop layer.

32. The method of Claim 31, wherein the etchant comprises an aqueous acid.

33. The method of Claim 26, wherein the sacrificial layer comprises at least one of amorphous silicon, germanium and molybdenum.

34. The method of Claim 33, wherein the etch stop layer comprises at least one of a silicon oxide, amorphous silicon, a silicon nitride, germanium, titanium, and tungsten.

35. An unreleased interferometric modulator made or manufacturable by the method of Claims 26 to 29 or 31 to 34.

36. The method of Claim 28 wherein:
the sacrificial layer comprises at least one of amorphous silicon, germanium and molybdenum;
the etch stop layer has a thickness in the range of about 100 Å to about 700 Å, the etch stop layer comprising at least one of a silicon oxide, amorphous silicon, a silicon nitride, germanium, titanium, and tungsten; and
the second mirror layer comprises at least one of Al, Al-Si, Al-Cu, Al-Ti, and Al-Nd.

37. The unreleased interferometric modulator of Claim 1, wherein said uniform layer comprises a thin layer relative to at least one sacrificial layer and the metal mirror layer.
